(19) Europäisches Patentamt
European Patent Office
Office européen des brevets

(11) **EP 4 668 019 A1**

(12) **EUROPEAN PATENT APPLICATION**
published in accordance with Art. 153(4) EPC

(43) Date of publication:
**24.12.2025 Bulletin 2025/52**

(21) Application number: **25755262.0**

(22) Date of filing: **14.02.2025**

(51) International Patent Classification (IPC):
***G03F 7/075*** *(2006.01)* ***C08F 287/00*** *(2006.01)*
***C08F 2/44*** *(2006.01)* ***C08F 2/50*** *(2006.01)*
***C08G 77/42*** *(2006.01)* ***C08G 77/38*** *(2006.01)*
***C08G 77/12*** *(2006.01)* ***C08K 5/101*** *(2006.01)*
***G03F 7/004*** *(2006.01)* ***G03F 7/027*** *(2006.01)*

(52) Cooperative Patent Classification (CPC):
**C08F 2/44; C08F 2/50; C08F 287/00; C08G 77/12; C08G 77/38; C08G 77/42; C08K 5/101; G03F 7/004; G03F 7/027; G03F 7/075; G03F 7/105**

(86) International application number:
**PCT/KR2025/002192**

(87) International publication number:
**WO 2025/174115 (21.08.2025 Gazette 2025/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.02.2024 KR 20240022505**

(71) Applicant: **LG CHEM, LTD.**
**Seoul 07336 (KR)**

(72) Inventors:
- **YI, Yeonhui**
  **Daejeon 34122 (KR)**
- **LEE, Hanna**
  **Daejeon 34122 (KR)**
- **KIM, Min Soo**
  **Daejeon 34122 (KR)**
- **JUNG, Soonhwa**
  **Daejeon 34122 (KR)**
- **HEO, Yongjoon**
  **Daejeon 34122 (KR)**
- **HONG, Chulsuk**
  **Daejeon 34122 (KR)**

(74) Representative: **Plasseraud IP**
**104 Rue de Richelieu**
**CS92104**
**75080 Paris Cedex 02 (FR)**

(54) **PHOTOPOLYMER COMPOSITION, HOLOGRAM RECORDING MEDIUM, METHOD FOR MANUFACTURING SAME, AND OPTICAL ELEMENT COMPRISING SAME**

(57) The present disclosure relates to a photopolymer composition, a hologram recording medium, a preparation method thereof, and an optical element comprising the same. The photopolymer composition is able to provide a hologram recording medium and an optical element comprising the same, which exhibit not only excellent optical recording characteristics but also outstanding reliability and transparency even under high temperatures.

EP 4 668 019 A1

【FIG. 1】

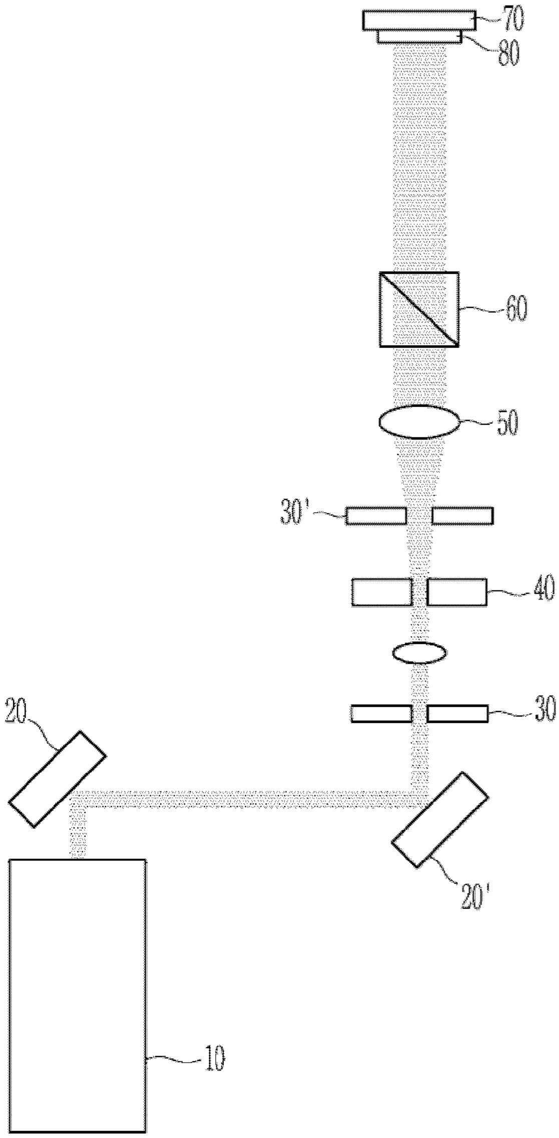

## Description

## [TECHNICAL FIELD]

Cross-reference to Related Application(s)

This application claims the benefit of Korean Patent Application No. 10-2024-0022505 filed on February 16, 2024 in the Korean Intellectual Property Office, the disclosures of which are herein incorporated by reference in their entirety.

The present disclosure relates to a photopolymer composition, a hologram recording medium, a preparation method thereof, and an optical element comprising the same.

## [BACKGROUND OF ART]

Hologram recording medium records information by changing a refractive index in the holographic recording layer in the medium through an exposure process, reads the variation of refractive index in the medium thus recorded, and reproduces the information.

In this regard, a photopolymer composition can be used for preparing a hologram. The photopolymer can easily store light interference pattern as a hologram by photopolymerization of a photoreactive monomer. Therefore, the photopolymer can be used in various fields such as, for example, smart devices such as mobile devices, wearable display parts, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

Specifically, a photopolymer composition for preparing a hologram includes a polymer matrix, a photoreactive monomer, and a photoinitiator system, and the photopolymer layer prepared from such a composition is irradiated with laser interference light to induce photopolymerization of local monomers.

A refractive index modulation is generated through this local photopolymerization process, and a diffraction grating is generated by such a refractive index modulation. The refractive index modulation value ($\triangle n$) is influenced by the thickness and the diffraction efficiency (DE) of the photopolymer layer, and the angular selectivity increases as the thickness decreases.

Recently, a request for development of materials capable of maintaining a stable hologram with a high diffraction efficiency has been increased, and also various attempts have been made to prepare a photopolymer layer having high diffraction efficiency and high refractive index modulation values as well as a thin thickness.

On the other hand, when the hologram recording medium is used as an optical element in applications such as mobile devices or vehicle parts (e.g., head up displays), it is placed under high temperature environments. In such a case, while deformation of the diffraction grating occurs, the image becomes distorted and the originally intended function may not be performed.

Therefore, there is a need to develop a photopolymer layer with less deformation of the diffraction grating and excellent reliability despite the heat of the usage environment and a hologram recording medium comprising the same.

## [DETAILED DESCRIPTION OF THE INVENTION]

### [Technical Problem]

According to an embodiment of the present disclosure, a photopolymer composition is provided.

According to another embodiment of the present disclosure, a hologram recording medium is provided.

According to yet another embodiment of the present disclosure, a method for preparing the hologram recording medium is provided.

According to a further embodiment of the present disclosure, an optical element comprising the hologram recording medium is provided.

### [Technical Solution]

Hereinafter, a photopolymer composition, a hologram recording medium, a preparation method thereof, an optical element comprising the same, and the like according to specific embodiments of the present disclosure will be described.

The term "hologram recording medium" as used herein means a medium (or media) on which optical information can be recorded in an entire visible range and an ultraviolet range (e.g., 300 to 1,200 nm) through an exposure process,

unless specifically stated otherwise. The hologram herein may include all of visual holograms such as in-line (Gabor) holograms, off-axis holograms, full-aperture transfer holograms, white light transmission holograms ("rainbow holograms"), Denisyuk holograms, off-axis reflection holograms, edge-literature holograms or holographic stereograms.

In this specification, in relation to environmental conditions, etc. under which a hologram recording medium or a device including the same is placed, "high temperature" may mean a temperature of 60°C or more. For example, the high temperature may mean a temperature of 65°C or more, 70°C or more, 75°C or more, 80°C or more, 85°C or more, or 90°C or more, and the upper limit thereof is not particularly limited, but may be, for example, 110°C or less, 105°C or less, 100°C or less, 95°C or less, 90°C or less, 85°C or less, or 80°C or less. When temperature affects the characteristics of a material, object, or component, unless temperature is specifically mentioned otherwise, the temperature condition under which the characteristic is measured or explained may mean a room temperature (e.g., a temperature in the range of about 15 to 30°C which is a temperature without heating or cooling).

In this specification, unless otherwise stated, the measured values are understood to be those of a photopolymer layer comprised in a hologram recording medium.

According to one embodiment of the disclosure, there is provided a photopolymer composition comprising: a polymer matrix formed by crosslinking a siloxane-based polymer containing a silane functional group and an acrylic-based polyol, or a precursor thereof; a fluorinated compound represented by the following Chemical Formula 1; a photoreactive monomer; and a photoinitiator system.

[Chemical Formula 1]

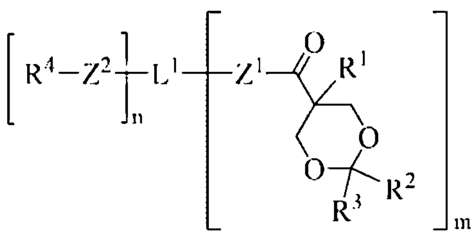

In Chemical Formula 1,

$Z^1$ is -O- or -NH-,
$Z^2$ is a single bond, -O-, or -NH-,
$L^1$ is a single bond or a divalent to hexavalent organic group in which hydroxy groups have been removed from a polyol having 2 to 6 hydroxyl groups,
n and m are each independently an integer of 1 to 5, wherein the sum of n and m is 2 to 6,
$R^1$, $R^2$, and $R^3$ are each independently methyl or ethyl,
$R^4$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines.

The present inventors have found through experiments that when a fluorinated compound having a specific structure is used as a plasticizer in a photopolymer composition, it is possible to provide a hologram recording medium with excellent optical recording characteristics, high reliability under high temperature conditions, and high transparency, and completed the present invention.

A photopolymer composition, a hologram recording medium formed from the photopolymer composition, a preparation method thereof, an optical element comprising the hologram recording medium, and the like according to one embodiment of the present disclosure will be described below.

The photopolymer composition according to one embodiment of the disclosure includes a polymer matrix or a precursor thereof that serves as a support for the photopolymer layer formed therefrom.

The polymer matrix is formed by crosslinking a siloxane-based polymer containing a silane functional group (Si-H) and an acrylic-based polyol. Specifically, the polymer matrix is formed by crosslinking an acrylic-based polyol with a siloxane-based polymer containing a silane functional group. More specifically, the hydroxy group of the acrylic-based polyol can form a crosslink with the silane functional group of the siloxane-based polymer through a hydrosilylation reaction. The hydrosilylation reaction can proceed rapidly under a Pt-based catalyst even at room temperature (e.g., a temperature in the range of about 15 to 30°C which is a temperature without heating or cooling). Therefore, the photopolymer composition according to one embodiment of the disclosure employs a polymer matrix that can be quickly crosslinked even at room temperature as a support, thereby being able to improve the preparation efficiency and

productivity.

The polymer matrix can enhance the mobility of components (e.g., photoreactive monomer or plasticizer, etc.) contained in the photopolymer layer due to the flexible main chain of the siloxane-based polymer. In addition, siloxane bonding having excellent heat resistance and moist heat resistance properties can facilitate ensuring reliability of the photopolymer layer in which optical information is recorded, and of the hologram recording medium including the same.

The polymer matrix may have a relatively low refractive index, which can serve to enhance the refractive index modulation of the layer formed from the photopolymer composition. For example, the upper limit of the refractive index of the polymer matrix may be 1.53 or less, 1.52 or less, 1.51 or less, 1.50 or less, or 1.49 or less. And, the lower limit of the refractive index of the polymer matrix may be, for example, 1.40 or more, 1.41 or more, 1.42 or more, 1.43 or more, 1.44 or more, 1.45 or more, or 1.46 or more. As used herein, "refractive index" may be a value measured with an Abbe refractometer at 25°C.

The photopolymer composition according to one embodiment of the disclosure may include the polymer matrix in crosslinked form as described above, or may include a precursor thereof. When the photopolymer composition includes a precursor of the polymer matrix, it may include a siloxane-based polymer, an acrylic-based polyol, and a Pt-based catalyst.

The siloxane-based polymer may include, for example, a repeating unit represented by the following Chemical Formula 2 and a terminal end group represented by the following Chemical Formula 3.

[Chemical Formula 2]

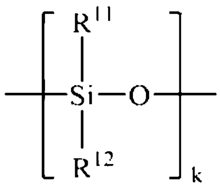

in Chemical Formula 2,

a plurality of $R^{11}$ and $R^{12}$ are the same or different from each other, and are each independently hydrogen, halogen, or an alkyl group having 1 to 10 carbon atoms, and
k is an integer of 1 to 10,000,

[Chemical Formula 3]

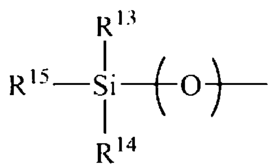

in Chemical Formula 3,
a plurality of $R^{13}$ to $R^{15}$ are the same or different from each other, and are each independently hydrogen, halogen, or an alkyl group having 1 to 10 carbon atoms, and
at least one of $R^{11}$ to $R^{15}$ of at least one repeating unit selected among the repeating units represented by Chemical Formula 2 and any one terminal end group selected among the terminal end groups represented by Chemical Formula 3 is hydrogen.

In Chemical Formula 3, -(O)- means either bonding through oxygen (O) or directly bonding without oxygen (O) when Si of the terminal end group represented by Chemical Formula 3 is bonded to the repeating unit represented by Chemical Formula 2.

As used herein, "alkyl group" may be a straight chain, branched chain, or cyclic alkyl group. By way of non-limiting example, "alkyl group" as used herein may be methyl, ethyl, propyl (e.g. n-propyl, isopropyl, etc.), butyl (e.g., n-butyl, isobutyl, tert-butyl, sec-butyl, cyclobutyl, etc.), pentyl (e.g., n-pentyl, isopentyl, neopentyl, tert-pentyl, 1,1-dimethyl-propyl, 1-ethyl-propyl, 1-methyl-butyl, cyclopentyl, etc.), hexyl (e.g., n-hexyl, 1-methylpentyl, 2-methylpentyl, 4-methylpentyl, 3,3-dimethylbutyl, 1-ethyl-butyl, 2-ethylbutyl, cyclopentylmethyl, cyclohexyl, etc.), heptyl (e.g., n-heptyl, 1-methylhexyl, 4-methylhexyl, 5-methylhexyl, cyclohexylmethyl, etc.), octyl (e.g., n-octyl, tert-octyl, 1-methylheptyl, 2-ethylhexyl, 2-propylpentyl, etc.), nonyl (e.g., n-nonyl, 2,2-dimethylheptyl, etc.), and the like.

In one example, $R^{11}$ to $R^{15}$ in Chemical Formulas 2 and 3 are methyl or hydrogen, and at least two of $R^{11}$ to $R^{15}$ may be hydrogen. More specifically, the siloxane-based polymer may be a compound in which $R^{11}$ and $R^{12}$ of Chemical Formula 2 are each independently methyl and hydrogen, and $R^{13}$ to $R^{15}$ of Chemical Formula 3 are each independently methyl or hydrogen (e.g., polymethylhydrosiloxane whose terminal end group is a trimethylsilyl group or a dimethylhydrosilyl group); a compound in which some $R^{11}$ and $R^{12}$ of Chemical Formula 2 are methyl and hydrogen, respectively, both the remaining $R^{11}$ and $R^{12}$ are methyl, and $R^{13}$ to $R^{15}$ of Chemical Formula 3 are each independently methyl or hydrogen (e.g., poly(dimethylsiloxane-co-methylhydrosiloxane) whose terminal end group is a trimethylsilyl group or a dimethylhydrosilyl group); or a compound in which both $R^{11}$ and $R^{12}$ of Chemical Formula 2 are methyl, at least one of $R^{13}$ to $R^{15}$ of Chemical Formula 3 is hydrogen, and the remainder are each independently methyl or hydrogen (e.g., polydimethylsiloxane in which either or both of the terminal end groups are dimethylhydrosilyl groups).

The siloxane-based polymer may have a number average molecular weight (Mn) in the range of 200 to 4,000 as an example. Specifically, the lower limit of the number average molecular weight of the siloxane-based polymer may be, for example, 200 or more, 250 or more, 300 or more, or 350 or more, and the upper limit thereof may be, for example, 3,500 or less, 3,000 or less, 2,500 or less, 2,000 or less, 1,500 or less, or 1,000 or less. When the number average molecular weight of the siloxane-based polymer satisfies the above range, it is possible to prevent the problems that during the crosslinking process with an acrylic-based polyol which is performed at room temperature or higher, the siloxane-based polymer volatilizes and the degree of matrix crosslinking decreases, or the siloxane-based polymer has poor compatibility with other components of the photopolymer composition and thus, phase separation occurs between the components, thereby allowing the hologram recording medium formed from the photopolymer composition to exhibit excellent optical recording characteristics and durability under high temperature conditions.

The number average molecular weight means a number average molecular weight (unit: g/mol) in terms of polystyrene determined by GPC method. In the process of determining the number average molecular weight in terms of polystyrene measured by the GPC method, a commonly known analyzing device, a detector such as a refractive index detector, and an analytical column may be used, and commonly applied conditions for temperature, solvent, and flow rate may be used. Specific examples of the measurement conditions may include a temperature of 25°C, tetrahydrofuran solvent and a flow rate of 1 mL/min.

The acrylic-based polyol may mean a polymer in which one or more, specifically two or more, hydroxy groups are bonded to the main chain or side chain of an acrylate-based polymer. Unless specifically stated otherwise, "acrylic-based" as used herein refers to one or more selected from the group consisting of acryloyl group, methacryloyl group and derivatives thereof, or a repeating unit formed by polymerization thereof. Unless specifically stated otherwise, "acrylate-based" as used herein refers to one or more selected from the group consisting of acrylate and methacrylate, or a repeating unit formed by polymerization thereof.

The acrylic-based polyol is a homopolymer of an acrylate-based monomer having a hydroxy group, a copolymer of two or more types of acrylate-based monomers having a hydroxy group, or a copolymer of an acrylate-based monomer having a hydroxy group and an acrylate-based monomer having no hydroxy group. As used herein, "copolymer" is a term that encompasses all of a random copolymer, a block copolymer and a graft copolymer, unless otherwise specified.

The acrylate-based monomer having a hydroxy group may include, for example, hydroxyalkyl (meth)acrylate, hydroxyaryl (meth)acrylate, or the like, the alkyl is an alkyl having 1 to 30 carbon atoms, and the aryl may be an aryl having 6 to 30 carbon atoms. Further, the acrylate-based monomer having no hydroxy group may include, for example, an alkyl (meth)acrylate, an aryl (meth)acrylate, or the like, the alkyl may be an alkyl having 1 to 30 carbon atoms, and the aryl may be an aryl having 6 to 30 carbon atoms. Unless specifically stated otherwise, "(meth)acrylate" as used herein refers to acrylate and/or methacrylate.

The acrylic-based polyol may have a weight average molecular weight (Mw) in the range of 150,000 to 1,000,000 as an example. The weight average molecular weight means a weight average molecular weight in terms of polystyrene measured by the GPC method as described above. For example, the lower limit of the weight average molecular weight may be 150,000 or more, 200,000 or more, or 250,000 or more, and the upper limit thereof may be, for example, 900,000 or less, 850,000 or less, 800,000 or less, 750,000 or less, 700,000 or less, 650,000 or less, 600,000 or less, 550,000 or less, 500,000 or less, or 450,000 or less. When the weight average molecular weight of the acrylic-based polyol satisfies the above range, the polymer matrix sufficiently exerts the function as a support and thus, the recording properties for optical information less decrease even after the usage time has passed, and sufficient flexibility is imparted to the polymer matrix, thereby being able to improve the mobility of components (e.g., photoreactive monomer or plasticizer, etc.) contained in the photopolymer composition, and minimize the decrease in recording properties for optical information.

In order to adjust the crosslinking density of the acrylic-based polyol by the siloxane-based polymer at a level that is advantageous for ensuring the function of the hologram recording medium, the hydroxyl group equivalent of the acrylic-based polyol may be adjusted to an appropriate level.

Specifically, the hydroxyl group (-OH) equivalent of the acrylic-based polyol may be, for example, in the range of 500 to 3,000 g/equivalent. More specifically, the lower limit of the hydroxyl group (-OH) equivalent of the acrylic-based polyol may be 600 g/equivalent or more, 700 g/equivalent or more, 800 g/equivalent or more, 900 g/equivalent or more,

1000 g/equivalent or more, 1100 g/equivalent or more, 1200 g/equivalent or more, 1300 g/equivalent or more, 1400 g/equivalent or more, 1500 g/equivalent or more, 1600 g/equivalent or more, 1700 g/equivalent or more, or 1750 g/equivalent or more. And, the upper limit of the hydroxyl group (-OH) equivalent of the acrylic-based polyol may be 2900 g/equivalent or less, 2800 g/equivalent or less, 2700 g/equivalent or less, 2600 g/equivalent or less, 2500 g/equivalent or less, 2400 g/equivalent or less, 2300 g/equivalent or less, 2200 g/equivalent or less, 2100 g/equivalent or less, 2000 g/equivalent or less, or 1900 g/equivalent or less. The hydroxyl group (-OH) equivalent of the acrylic-based polyol means the equivalent weight (g/equivalent) for each single hydroxyl group, and is the value obtained by dividing the weight average molecular weight of the acrylic-based polyol by the number of hydroxyl groups per molecule. Therefore, as the equivalent value is smaller, the density of the functional group is higher, and as the equivalent value is larger, the density of the functional group is smaller. When the hydroxyl (-OH) equivalent of the acrylic-based polyol satisfies the above range, the polymer matrix has an appropriate crosslinking density and thus, sufficiently performs the role of a support, and the mobility of the components included in the layer formed from the photopolymer composition is improved, which allows the initial refractive index modulation value to be maintained at an excellent level even as time passes without the problem of collapsing the boundary surfaces of the diffraction gratings generated after recording, thereby minimizing the decrease in recording properties for optical information.

For example, the acrylic-based polyol may have a glass transition temperature (Tg) in the range of -60 to -10°C. Specifically, the lower limit of the glass transition temperature may be, for example, -55°C or more, -50°C or more, -45°C or more, -40°C or more, -35°C or more, -30°C or more, or -25°C or more, and the upper limit thereof may be, for example, -15°C or less, -20°C or less, -25°C or less, -30°C or less, or -35°C or less. If the above glass transition temperature range is satisfied, it is possible to lower the glass transition temperature without significantly reducing the modulus of the polymer matrix, thereby increasing the mobility (fluidity) of other components in the photopolymer composition, and also improving the moldability of the photopolymer composition. The glass transition temperature may be measured using a known method, for example, DSC (Differential Scanning Calorimetry) or DMA (dynamic mechanical analysis).

The refractive index of the acrylic-based polyol may be, for example, 1.40 or more and less than 1.50. Specifically, the lower limit of the refractive index of the acrylic-based polyol may be, for example, 1.41 or more, 1.42 or more, 1.43 or more, 1.44 or more, 1.45 or more, or 1.46 or more, and the upper limit thereof may be, for example, 1.49 or less, 1.48 or less, 1.47 or less, 1.46 or less, or 1.45 or less. When the acrylic-based polyol has a refractive index within the above-mentioned range, it can contribute to increasing the refractive index modulation. The refractive index of the acrylic-based polyol is a theoretical refractive index, and may be calculated using the refractive index (value measured using an Abbe refractometer at 25°C) of the monomer used for preparing the acrylic-based polyol and the fraction (molar ratio) of each monomer.

The acrylic-based polyol and the siloxane-based polymer may be included so that the molar ratio (SiH/OH) of the silane functional group (Si-H) of the siloxane-based polymer to the hydroxyl group (-OH) of the acrylic-based polyol is 0.80 to 3.5. That is, the type and content of the siloxane-based polymer and the acrylic-based polyol may be selected so as to satisfy the molar ratio when forming the polymer matrix. The lower limit of the molar ratio (SiH/OH) may be, for example, 0.81 or more, 0.85 or more, 0.90 or more, or 0.95 or more, and the upper limit thereof may be, for example, 3.4 or less, 3.3 or less, 3.2 or less, 3.1 or less, 3.05 or less, or 3.0 or less. When satisfying the above molar ratio (SiH/OH) range, the polymer matrix is crosslinked at an appropriate crosslinking density, so that reliability under high temperature conditions is improved, and a sufficient refractive index modulation value can be realized.

The Pt-based catalyst may be, for example, Karstedt's catalyst, and the like. The precursor of the polymer matrix may optionally further include rhodium-based catalysts, iridium-based catalysts, rhenium-based catalysts, molybdenum-based catalysts, iron-based catalysts, nickel-based catalysts, alkali metal or alkaline earth metal-based catalysts, Lewis acids-based or carbene-based non-metallic catalysts, in addition to the Pt-based catalyst.

On the other hand, a hologram recording medium may be prepared by irradiating an object light and a reference light onto a photopolymer layer formed from the photopolymer composition according to one embodiment of the disclosure. Due to the interference field between the object light and the reference light, photopolymerization of the photoreactive monomer does not occur in the destructive interference region, but photopolymerization of the photoreactive monomer occurs in the constructive interference region. As the photoreactive monomer is continuously consumed in the constructive interference region, a concentration difference occurs between the photoreactive monomer in the destructive interference region and the constructive interference region, and as a result, the photoreactive monomer in the destructive interference region diffuses into the constructive interference region. A diffraction grating is generated by the refractive index modulation thus generated.

Therefore, the photoreactive monomer may include a compound having a higher refractive index than the polymer matrix in order to realize the above-described refractive index modulation. However, all photoreactive monomers contained in the photopolymer composition according to one embodiment of the disclosure are not limited to those having a higher refractive index than the polymer matrix, and at least a part of the photoreactive monomers may have a higher refractive index than the polymer matrix, so as to realize a high refractive index modulation value. In one example, the photoreactive monomer may include a monomer having a refractive index of 1.50 or more, 1.51 or more, 1.52 or more, 1.53

or more, 1.54 or more, 1.55 or more, 1.56 or more, 1.57 or more, 1.58 or more, 1.59 or more, or 1.60 or more, and 1.70 or less.

The photoreactive monomer may include at least one monomer selected from the group consisting of a monofunctional monomer having one photoreactive functional group and a polyfunctional monomer having two or more photoreactive functional groups. Wherein, the photoreactive functional group may be, for example, a (meth)acryloyl group, a vinyl group, a thiol group, or the like. More specifically, the photoreactive functional group may be a (meth)acryloyl group.

The monofunctional monomer may include, for example, at least one selected from the group consisting of benzyl (meth)acrylate (M1182 having a refractive index of 1.5140, Miwon Specialty Chemical), benzyl 2-phenylacrylate, phenoxybenzyl (meth)acrylate (M1122 having a refractive index of 1.565, Miwon Specialty Chemical), phenol (ethylene oxide) (meth)acrylate (phenol (EO) (meth)acrylate; M140 having a refractive index of 1.516, Miwon Specialty Chemical), phenol (ethylene oxide)$_2$ (meth)acrylate (phenol (EO)$_2$ (meth)acrylate; M142 having a refractive index of 1.510, Miwon Specialty Chemical), O-phenylphenol (ethylene oxide) (meth)acrylate (O-phenylphenol (EO) (meth)acrylate; M1142 having a refractive index of 1.577, Miwon Specialty Chemical), phenylthioethyl (meth)acrylate (M1162 having a refractive index of 1.560, Miwon Specialty Chemical) and biphenylmethyl (meth)acrylate.

The polyfunctional monomer may include, for example, at least one selected from the group consisting of bisphenol A (ethylene oxide)$_{2\sim10}$ di(meth)acrylate (bisphenol A (EO)$_{2\sim10}$ (meth)acrylate; M240 having a refractive index of 1.537, M241 having a refractive index of 1.529, M244 having a refractive index of 1.545, M245 having a refractive index of 1.537, M249 having a refractive index of 1.542, M2100 having a refractive index of 1.516, M2101 having a refractive index of 1.512, Miwon Specialty Chemical), bisphenol A epoxy di(meth)acrylate (PE210 having a refractive index of 1.557, PE2120A having a refractive index of 1.533, PE2120B having a refractive index of 1.534, PE2020C having a refractive index of 1.539, PE2120S having a refractive index of 1.556, Miwon Specialty Chemical), bisfluorene di(meth)acrylate (HR6022 having a refractive index of 1.600, HR6040 having a refractive index of 1.600, HR6042 having a refractive index of 1.600, Miwon Specialty Chemical), modified bisphenol fluorene di(meth)acrylate (HR6060 having a refractive index of 1.584, HR6100 having a refractive index of 1.562, HR6200 having a refractive index of 1.530, Miwon Specialty Chemical), tris(2-hydroxyethyl)isocyanurate tri(meth)acrylate (M370 having a refractive index of 1.508, Miwon Specialty Chemical), phenol novolac epoxy (meth)acrylate (SC6300 having a refractive index of 1.525, Miwon Specialty Chemical) and cresol novolac epoxy (meth)acrylate (SC6400 having a refractive index of 1.522, SC6400C having a refractive index of 1.522, Miwon Specialty Chemical).

The photopolymer composition according to one embodiment of the disclosure may contain a photoreactive monomer in an amount of 50 to 300 parts by weight based on 100 parts by weight of the polymer matrix. For example, the lower limit of the content of the photoreactive monomer may be 50 parts by weight or more, 60 parts by weight or more, 70 parts by weight or more, 80 parts by weight or more, or 90 parts by weight or more, and the upper limit thereof may be 300 parts by weight or less, 280 parts by weight or less, 250 parts by weight or less, 220 parts by weight or less, 200 parts by weight or less, 190 parts by weight or less, or 180 parts by weight or less. Wherein, "the content of polymer matrix" means the total content (weight) of the acrylic-based polyol and the siloxane-based polymer forming the matrix. When the above range is satisfied, it is advantageous for ensuring excellent optical recording characteristics and durability under high temperature conditions.

In this specification, the content of the polymer matrix means the total content (weight) of the acrylic-based polyol and siloxane-based polymer forming the matrix. In other words, the content of the polymer matrix means including both the content of the polymer matrix formed by crosslinking acrylic-based polyol and siloxane-based polymer and the content of the polymer matrix precursor that is not partially crosslinked.

The photopolymer composition according to one embodiment of the disclosure includes a photoinitiator system. The photoinitiator system may mean a photoinitiator that enables polymerization to initiate by light, or a combination of a photosensitizer and a co-initiator.

The photopolymer composition of one embodiment may include a photosensitizer and a co-initiator as a photoinitiator system.

As the photosensitizer, a photosensitizing dye may be used. Specifically, the photosensitizing dye may include, for example, at least one selected from the group consisting of a silicon rhodamine compound, a sulfonium derivative of ceramidonine, new methylene blue, thioerythrosine triethylammonium, 6-acetylamino-2-methylceramidonin, eosin, erythrosine, rose bengal, thionine, basic yellow, Pinacyanol chloride, rhodamine 6G, gallocyanine, ethyl violet, Victoria blue R, Celestine blue, Quinaldine Red, Crystal violet, Brilliant Green, Astrazon orange G, darrow red, pyronin Y, basic red 29, pyrylium I (pyrylium iodide), Safranin O, cyanine, methylene blue, Azure A, and BODIPY.

In one example, as the photosensitizing dye, cyanine dyes Cy3 and Cy5 (H-Nu 640, Spectra Group Limited) may be used, or Safranin O may be used.

The photopolymer composition of one embodiment may include the photosensitizing dye in an amount of 0.01 to 10 parts by weight based on 100 parts by weight of the polymer matrix. Specifically, the lower limit of the content of the photosensitizing dye may be, for example, 0.05 parts by weight or more, 0.07 parts by weight or more, or 0.10 parts by

weight or more, and the upper limit may be, for example, 5 parts by weight or less. When the above range is satisfied, it is advantageous for exhibiting an appropriate polymerization reaction rate and ensuring desired optical recording characteristics.

The co-initiator may include an electron donor, an electron acceptor, or a mixture thereof.

In one example, the photopolymer composition of one embodiment may include an electron donor as a co-initiator. The electron donor may include, for example, a borate anion represented by the following Chemical Formula 4.

[Chemical Formula 4] $BX^1X^2X^3X^4$

in Chemical Formula 4, $X^1$ to $X^4$ are each independently an alkyl group having 1 to 20 carbon atoms, an alkenyl group having 2 to 20 carbon atoms, an aryl group having 6 to 30 carbon atoms, an arylalkyl group having 7 to 30 carbon atoms, an alkylaryl group having 7 to 30 carbon atoms, or an allyl group, each of which is substituted or unsubstituted, with the proviso that at least one of $X^1$ to $X^4$ is not an aryl group.

When the alkyl group having 1 to 20 carbon atoms, the alkenyl group having 2 to 20 carbon atoms, the aryl group having 6 to 30 carbon atoms, the arylalkyl group having 7 to 30 carbon atoms, the alkylaryl group having 7 to 30 carbon atoms, or the allyl group is substituted, it may be substituted with at least one selected from the group consisting of a halogen and an alkoxy group having 1 to 5 carbon atoms.

Specifically, $X^1$ to $X^3$ may be each independently methyl, ethyl, propyl, n-butyl, n-pentyl, n-hexyl, cyclobutyl, cyclopentyl, cyclohexyl, ethenyl, propenyl, phenyl, methylphenyl, methoxyphenyl, naphthyl, methylnaphthyl, or methoxynaphthyl, which is substituted or unsubstituted with halogen, and $X^4$ may be n-butyl, n-pentyl, or n-hexyl. More specifically, the borate anion represented by Chemical Formula 4 may be, for example, a triphenylbutyl borate anion.

The cation bonded to the borate anion does not absorb light, and may be an alkali metal cation, or a quaternary ammonium cation. The quaternary ammonium cation may be an ammonium cation in which nitrogen (N) is substituted with four substituents, and the four substituents are each independently an alkyl group having 1 to 40 carbon atoms, an aryl group having 6 to 30 carbon atoms, an arylalkyl group having 6 to 40 carbon atoms, or an alkyl group having 2 to 40 carbon atoms connected through an ester bond (e.g.,$-CH_2CH_2-O-CO-CH_2CH_2CH_3$,etc.).

As the electron donor, for example, commercially available butyryl choline triphenylbutylborate (Borate V, manufactured by Spectra Group) may be used.

In one example, the photopolymer composition may include an electron acceptor as a co-initiator. The electron acceptor may include, for example, an onium salt such as a sulfonium salt, an iodonium salt, or a mixture thereof.

In one example, the electron acceptor may include an iodonium salt. As the electron acceptor, for example, commercially available H-Nu 254 (Spectra Group) may be used.

The photopolymer composition may include the co-initiator in the range of 0.05 to 10 parts by weight based on 100 parts by weight of the polymer matrix. Specifically, the lower limit of the content of the co-initiator may be, for example, 0.1 part by weight or more, 0.2 part by weight or more, 0.3 part by weight or more, 0.4 part by weight or more, or 0.5 part by weight or more, and the upper limit thereof may be, for example, 5 parts by weight or less. When the above range is satisfied, it is advantageous for exhibiting an appropriate polymerization reaction rate and ensuring the desired optical recording properties.

The photoinitiator system may include an additional photoinitiator in order to remove the color of the photosensitizing dye and react all unreacted photoreactive monomers after light irradiation for recording. The photoinitiator may include, for example, acetophenone-based compounds, oxime-based compounds, phosphine oxide-based compounds, thioxanthone-based compounds, benzoate-based compounds, imidazole-based compounds, N-aryl glycine derivatives, organic azide compounds, titanocenes, aluminate complexes, organic peroxides, N-alkoxy pyridinium salts, amine derivatives, diazonium salts, sulfonium salts, iodonium salts, sulfonates, imide sulfonates, dialkyl-4-hydroxysulfonium salts, aryl sulfonic acid-p-nitrobenzyl esters, silanol-aluminum complexes, (η6-benzene) (η5-cyclopentadienyl)iron(II), benzoin tosylate, 2,5-dinitrobenzyl tosylate, N-tosylphthalimide, or mixtures thereof, etc.

More specifically, the photoinitiator may include 2-methyl-1-[4-(methylthio)phenyl]-2-morpholinopropan-1-one, 2-benzyl-2-dimethylamino-1-(4-morpholinophenyl)-butan-1-one (Irgacure 369), 1-[9-ethyl-6-(2-methylbenzoyl)-9H-carbazol-3-yl]ethanone-1-(O-acetyl oxime) (Irgacure OXE02, BASF), [(Z)-(1-oxo-1-phenylpropan-2-ylidene)amino] benzoate (e.g., TPI-057 or TPI-059, manufactured by TREEEL), diphenyl(2,4,6-trimethylbenzoyl)phosphine oxide (Irgacure TPO), bis(2,6-dimethoxybenzoyl)-2,4,4-trimethylpentyl phosphine oxide (Irgacure 1700), phenylbis(2,4,6-trimethylbenzoyl)phosphine oxide (BAPO), bis(2,4,6-trimethylbenzoyl)phenylphosphine oxide (Irgacure 819), 2,4-diethyl thioxanthone, 2-chloro thioxanthone, isopropyl thioxanthone, diisopropyl thioxanthone, ethyl 4-(dimethylamino)benzoate, 1,3-di(t-butyldioxycarbonyl)benzophenone, 3,3',4,4"-tetrakis(t-butyldioxycarbonyl)benzophenone, 3-phenyl-5-isoxazoline, 2-mercaptobenzimidazole, bis(2,4,5-triphenyl)imidazole, 2,2-dimethoxy-1,2-diphenylethan-1-one (Irgacure 651), 1-hydroxycyclohexyl phenyl ketone (Irgacure 184), bis(η5-2,4-cyclopentadien-1-yl)-bis(2,6-difluoro-3-(1H-pyrrol-1-yl)phenyl)titanium (Irgacure 784), Ebecryl P-115 (SK entis), Cyracure UVI-6970, Cyracure UVI-6974, Cyracure UVI-6990 (Dow Chemical Co. in the USA), Irgacure 264, Irgacure 250 (BASF), CIT-1682 (Nippon Soda), or mixtures thereof, but are not

limited thereto.

The photopolymer composition according to one embodiment of the disclosure includes a fluorinated compound as a plasticizer.

The plasticizer can more easily realize refractive index modulation upon recording a hologram recording medium. More specifically, the plasticizer lowers the glass transition temperature of the polymer matrix, improves the mobility of the photoreactive monomer, and has a low refractive index and non-reactive properties. Thus, when a photoreactive monomer that is uniformly distributed within the polymer matrix but is not photopolymerized moves, it can move in the direction opposite thereto and contribute to the refractive index modulation. Further, the plasticizer can also contribute to improving the moldability of photopolymer compositions.

The fluorinated compound may have a low refractive index of 1.45 or less in order to perform the above-described plasticizer function. Specifically, the upper limit of the refractive index may be, for example, 1.44 or less, 1.43 or less, 1.42 or less, 1.41 or less, 1.40 or less, 1.39 or less, 1.38 or less, or 1.37 or less. The lower limit of the refractive index may be, for example, 1.30 or more, 1.31 or more, 1.32 or more, 1.33 or more, 1.34 or more, or 1.35 or more. Since a fluorinated compound having a lower refractive index than the above-mentioned photoreactive monomer is used, the refractive index of the polymer matrix can be further lowered, and the refractive index modulation with the photoreactive monomer can be made larger.

A non-reactive plasticizer is dispersed within the polymer matrix, which is the support of the photopolymer layer, without being chemically bonded to it. Accordingly, a non-reactive plasticizer may migrate to the surface of the photopolymer layer depending on the environment in which the hologram recording medium is used, and especially at high temperature it may readily migrate to the surface. The plasticizer that migrates to the surface forms a different refractive layer (or a layer having different refractive index) in the surface region of the photopolymer layer, and such a layer is a main cause of reduced reliability of the hologram recording medium.

The photopolymer composition of one embodiment may include the fluorinated compound that is hardly migrated to the surface of the photopolymer layer or is migrated to a negligible extent so that a different refractive layer is either not formed or is formed at an extremely minor level even under high temperatures. Accordingly, a hologram recording medium can be provided that can clearly reproduce the originally intended image and maintain high transparency even at high temperatures.

The photopolymer composition of one embodiment includes a fluorinated compound represented by the following Chemical Formula 1.

[Chemical Formula 1]

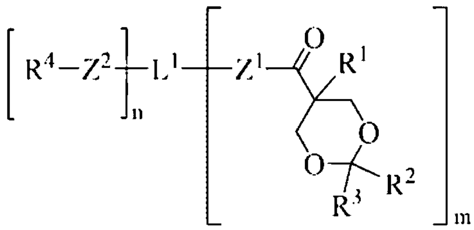

In Chemical Formula 1,

$Z^1$ is -O- or -NH-,
$Z^2$ is a single bond, -O-, or -NH-,
$L^1$ is a single bond or a divalent to hexavalent organic group in which hydroxy groups have been removed from a polyol having 2 to 6 hydroxyl groups,
n and m are each independently an integer of 1 to 5, wherein the sum of n and m is 2 to 6,
$R^1$, $R^2$, and $R^3$ are each independently methyl or ethyl,
$R^4$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines.

In Chemical Formula 1, $L^1$ connects the moiety containing a carbonyl group and the moiety containing $R^4$. Therefore, the sum of n and m is 2 to 6, which is equal to the number of bonds in $L^1$.

In one example, in Chemical Formula 1, $L^1$ may be a single bond. In Chemical Formula 1, when $L^1$ is a single bond, n and m are each 1, and $Z^2$ may also be a single bond. In such a case, the fluorinated compound represented by Chemical Formula 1 may be represented by the following Chemical Formula 1-1.

[Chemical Formula 1-1]

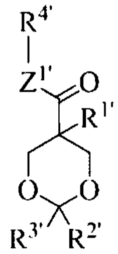

in Chemical Formula 1-1,

$Z^{1'}$, $R^{1'}$, $R^{2'}$, $R^{3'}$ and $R^{4'}$ are the same as $Z^1$, $R^1$, $R^2$, $R^3$ and $R^4$ in Chemical Formula 1, respectively. The $Z^{1'}$, $R^{1'}$, $R^{2'}$, $R^{3'}$ and $R^{4'}$ may be substituents described herein as specific examples of $Z^1$, $R^1$, $R^2$, $R^3$ and $R^4$ of Chemical Formula 1.

In another example, in Chemical Formula 1, $L^1$ may be a divalent to hexavalent organic group from which the hydroxyl groups have been removed from the polyol as the hydroxyl groups of the polyol having 2 to 6 hydroxyl groups are substituted with $Z^1$ and $Z^2$. In an example, the trivalent organic group from which the hydroxy groups have been removed from glycerol

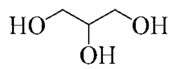

having three hydroxyl groups is represented as

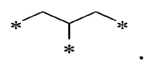

In Chemical Formula 1, the $L^1$ may be, for example, a divalent organic group in which the hydroxy groups have been removed from a diol such as ethanediol, propanediol, or butanediol; a trivalent organic group in which the hydroxy groups have been removed from a triol such as glycerol or trimethylolpropane; a tetravalent organic group in which the hydroxy groups have been removed from tetraol such as pentaerythritol or ditrimethylolpropane; a pentavalent organic group in which the hydroxy groups have been removed from pentaol, such as 6-methylheptanepentaol; or a hexavalent organic group in which the hydroxy groups have been removed from hexaol such as dipentaerythritol.

In Chemical Formula 1, when $L^1$ is a single bond or a divalent organic group, n and m are each 1. If the $L^1$ is a trivalent to hexavalent organic group, n may be larger than m. In one example, the n may be an integer of 1 to 3, and m may be an integer of 1.

In one example, the $L^1$ may be a trivalent organic group in which the hydroxy groups have been removed from glycerol which is a triol. And, n may be 2, and m may be 1. In such a case, the fluorinated compound represented by Chemical Formula 1 may be represented by the following Chemical Formula 1-2.

[Chemical Formula 1-2]

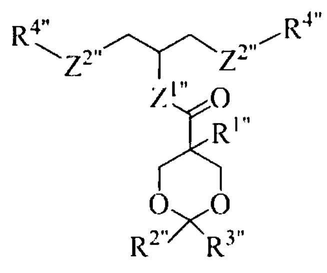

in Chemical Formula 1-2,

$Z^{1"}$, $Z^{2"}$, $R^{1"}$, $R^{2"}$, $R^{3"}$ and $R^{4"}$ are the same as $Z^1$, $Z^2$, $R^1$, $R^2$, $R^3$ and $R^4$ of Chemical Formula 1, respectively. The $Z^{1"}$, $Z^{2"}$, $R^{1"}$, $R^{2"}$, $R^{3"}$ and $R^{4"}$ may be substituents described herein as specific examples of $Z^1$, $Z^2$, $R^1$, $R^2$, $R^3$ and $R^4$ of Chemical Formula 1.

In Chemical Formula 1, the fluorine-containing substituent may be an alkyl group having 1 to 20 carbon atoms substituted with 2 or more fluorines, a cycloalkyl group having 3 to 30 carbon atoms substituted with 2 or more fluorines, or

an aryl group having 6 to 30 carbon atoms substituted with 2 or more fluorines. Specifically, the fluorine-containing substituent may be a straight chain alkyl group having 1 to 20 carbon atoms substituted with 2 or more fluorines. More specifically, the fluorine-containing substituent may be $-(CH_2)_a(CF_2)_bCHF_2$ or $-(CH_2)_a(CF_2)_bCF_3$. Wherein a is an integer of 0 to 3, an integer of 0 to 2, or an integer of 1, and b may be an integer of 0 to 19, an integer of 0 to 15, an integer of 0 to 12, an integer of 0 to 11, an integer of 0 to 10, or an integer of 0 to 9.

The photopolymer composition according to one embodiment of the disclosure may include the fluorinated compound in an amount of 20 to 200 parts by weight based on 100 parts by weight of the polymer matrix. Specifically, the lower limit of the content of the fluorinated compound may be, for example, 20 parts by weight or more, 25 parts by weight or more, 30 parts by weight or more, 35 parts by weight or more, 40 parts by weight or more, 45 parts by weight or more, 50 parts by weight or more, or 55 parts by weight or more, and the upper limit thereof may be, for example, 200 parts by weight or less, 180 parts by weight or less, 150 parts by weight or less, 120 parts by weight or less, or 100 parts by weight or less. When the above range is satisfied, it can represent large refractive index modulation values after recording due to the fluorinated compound having sufficient low refractive index, without problems of deteriorating the compatibility with the components contained in the photopolymer composition, of eluting some fluorinated compound to the surface of the photopolymer layer, or of degrading haze, which are advantageous for ensuring excellent optical recording properties.

The photopolymer composition of one embodiment may include the polymer matrix, the photoreactive monomer, and the fluorinated compound in a predetermined amount, thereby ensuring high reliability under high temperatures.

In one example, the photopolymer composition may include 25 to 40% by weight of the polymer matrix, 25 to 45% by weight of the photoreactive monomer, and 25 to 50% by weight of the fluorinated compound, based on the total weight of the polymer matrix, photoreactive monomer, and fluorinated compound.

More specifically, the polymer matrix may be contained, for example, in an amount of 25% by weight or more, and 40% by weight or less, 35% by weight or less, or 33% by weight or less. The photoreactive monomer may be contained, for example, in an amount of 25% by weight or more, 30% by weight or more or 33% by weight or more, and 45% by weight or less, 43% by weight or less, or 41% by weight or less. The fluorinated compound may be contained, for example, in an amount of 25% by weight or more, 30% by weight or more, or 33% by weight or more, and 50% by weight or less, 45% by weight or less, 40% by weight or less, or 38% by weight or less. Within this range, migration of the fluorinated compound to the surface under high temperatures can be effectively suppressed, thereby facilitating high reliability and high transparency under high temperatures.

The photopolymer composition of one embodiment may further include additives such as an antifoaming agent.

The photopolymer composition of one embodiment may include a silicone-based reactive additive as an antifoaming agent. As the silicone-based reactive additive, for example, commercially available products such as Tego Rad 2500 may be used.

The content of the antifoaming agent may be appropriately adjusted at a level that does not impede the function of the hologram recording medium.

The photopolymer composition of one embodiment may further include a solvent.

The solvent may be an organic solvent, and an example thereof may be at least one organic solvent selected from the group consisting of ketones, alcohols, acetates, and ethers, but is not limited thereto. Specific examples of such organic solvents include at least one selected from the group consisting of ketones such as methyl ethyl ketone, methyl isobutyl ketone, acetylacetone, or isobutyl ketone; alcohols such as methanol, ethanol, n-propanol, i-propanol, n-butanol, i-butanol, or t-butanol; acetates such as ethyl acetate, i-propyl acetate, or polyethylene glycol monomethyl ether acetate; and ethers such as tetrahydrofuran or propylene glycol monomethyl ether.

The organic solvent may be added at the time point when respective components contained in the photopolymer composition are mixed, or may be included in the photopolymer composition while respective components are added in a state of being dispersed or mixed in an organic solvent.

The photopolymer composition of one embodiment may include a solvent such that the solid content concentration is 1 to 90% by weight. Specifically, the photopolymer composition may include a solvent such that the solid concentration is 20% by weight or more, 30% by weight or more, 50% by weight or more, or 60% by weight or more, and 85% by weight or less, 80% by weight or less, 75% by weight or less, or 70% by weight or less. Within this range, the photopolymer composition exhibits appropriate flowability and can form a coating layer without defects such as stripes. No defects occur during the drying and curing process and thus, a photopolymer layer exhibiting desired physical properties and surface properties can be formed.

On the other hand, according to another embodiment of the disclosure, there is provided a hologram recording medium including a photopolymer layer formed from the photopolymer composition.

Since the hologram recording medium of another embodiment includes the fluorinated compound represented by Chemical formula 1, a different refractive layer which is formed by migration of a plasticizer in a photopolymer layer to the surface may be not formed or may be form at an extremely minor level even at high temperatures. Accordingly, the hologram recording medium can clearly reproduce the originally intended image and maintain high transparency even at high temperatures.

The hologram recording medium of another embodiment may have a sufficiently low Pn value calculated by the following Equation 1. In one example, the hologram recording medium of another embodiment may have a P80 calculated by the following Equation 1 (the thickness ratio of the different refractive layer formed at 80 °C) of 0.10% or less.

[Equation 1]

$$Pn\ (\%) = \{A1 / (A1 + A2)\} \times 100$$

In Equation 1, Pn is the thickness ratio of the different refractive layer formed at n °C,

A1 is the thickness of the different refractive layer formed at n °C, where the different refractive layer refers to the portion at the surface of the photopolymer layer exhibiting a refractive index difference of at least 0.0010% from the central refractive index measured at an incident angle of 70° and in the wavelength range of 320 to 1680 nm, and A2 is the thickness of the remainder of the photopolymer layer excluding the different refractive layer.

The different refractive layer refers to the portion at the surface of the photopolymer layer exhibiting a refractive index difference from the central refractive index of the photopolymer layer. Specifically, the refractive index difference is at least 0.0010% from the central refractive index. In one example, if the central refractive index of the photopolymer layer is 1.5, the different refractive layer may be defined based on the boundary where the refractive index is 0.000015 (= 1.5 × 0.00001) higher or lower than 1.5.

The thickness (A1) of the different refractive layer may be determined by measuring the refractive index from the surface to the center of the photopolymer layer in the wavelength range of 320 to 1680 nm and applying Equation 1. The thickness (A1) may be defined as the thickness observed at the wavelength at which the different refractive layer is thickest within that range.

The P80 of 0.10% or less means that even when the hologram recording medium is exposed to high temperature of 80 °C, migration of the fluorinated compound to the surface can be suppressed so that the degree of formation of the different refractive layer is minimal. Therefore, if Pn calculated by Equation 1 is sufficiently low, the hologram recording medium can clearly reproduce the originally intended image without a decrease in image reproduction capability under high temperatures.

The upper limit of P80 may be, for example, 0.10% or less, 0.09% or less, 0.08% or less, 0.07% or less, 0.06% or less, or 0.05% or less, and the lower limit thereof may be, for example, 0% or more.

Details regarding the method of measuring the refractive index for calculating Pn using Equation 1 and the specific conditions may be found in the Test Example 1 described below. In Equation 1, Pn may refer to the thickness ratio of the different refractive layer that is formed at n °C in the hologram recording medium before recording.

The hologram recording medium of another embodiment may have a small difference between the refractive indices at the center and at the surface. In one example, the difference in refractive index between the center and the surface within 0.05 % of thickness of the photopolymer layer at 80 °C may be 0.080 or less.

The difference in refractive index between the center and the surface within 0.05% of thickness at 80 °C may be, for example, 0.080 or less, 0.070 or less, 0.060 or less, 0.050 or less, 0.040 or less, 0.030 or less, 0.028 or less, or 0.026 or less. The lower limit of the refractive index difference is not particularly limited, but may be, for example, 0 or more, or 0.001 or more. The method and conditions for measuring the refractive index are provided in the Test Example 1 described below.

Since the hologram recording medium uses a mixture of a component having a low refractive index and a component having a high refractive index to record optical properties, it tends to have opaque characteristics due to their compatibility. Moreover, the decomposition or migration of a component having a low refractive index such as a plasticizer may render the hologram recording medium even more opaque under high temperatures.

However, since the hologram recording medium of another embodiment includes the fluorinated compound represented by Chemical Formula 1 as a plasticizer which exhibits minimal decomposition and migration even under high temperatures and shows excellent compatibility with components having high refractive indices, it maintains excellent transparency even when exposed to high temperatures.

Specifically, the hologram recording medium of another embodiment may have a sufficiently low △Hn value calculated by the following Equation 2. In one example, the hologram recording medium of another embodiment may have a △H80 calculated by the following Equation 2 (the haze increase at 80 °C) of 10 %p or less.

[Equation 2]

$$\triangle Hn\ (\%p) = B2 - B1$$

In Equation 2, △Hn is the haze increase of the hologram recording medium at n °C,

B1 is the initial haze of the hologram recording medium before being stored at n °C, and
B2 is the haze after the hologram recording medium is stored at n °C for 100 hours.

The △H80 of 10 %p or less means that even when the hologram recording medium is exposed to high temperatures of 80 °C, the migration of the fluorinated compound to the surface can be suppressed so that the haze increase is minimal. Therefore, if △Hn calculated by Equation 2 is sufficiently low, the hologram recording medium can exhibit transparent optical characteristics even under high temperatures.

The upper limit of △H80 may be, for example, 9 %p or less, 8 %p or less, 7 %p or less, 6 %p or less, 5 %p or less, 4 %p or less, 3 %p or less, 2.5 %p or less, 2 %p or less, 1.5 %p or less, or 1.0 %p or less. The lower limit of the haze increase is not particularly limited, but may be, for example, 0 %p or more. The haze increase may be measured by the method described in Test Example 2 described below. In Equation 2, △Hn may refer to the haze increase of the hologram recording medium after recording measured at n °C.

The hologram recording medium of another embodiment may further include a substrate on at least one surface of the photopolymer layer. The type of the substrate is not particularly limited, and those known in the related technical field may be used. For example, substrates such as glass, PET (polyethylene terephthalate), TAC (triacetyl cellulose), PC (polycarbonate), or COP (cycloolefin polymer) may be used.

Since the photopolymer layer is formed from the photopolymer composition, it can achieve excellent refractive index modulation and high diffraction efficiency despite having a thin thickness, thereby providing excellent optical recording characteristics and showing outstanding reliability even under high temperature conditions.

The thickness of the photopolymer layer may be, for example, in the range of 5.0 to 40.0 μm. Specifically, the lower limit of the thickness of the photopolymer layer may be, for example, 6 μm or more, 7 μm or more, 8 μm or more, or 9 μm or more. And, the upper limit of the thickness may be, for example, 35 μm or less, 30 μm or less, 29 μm or less, 28 μm or less, 27 μm or less, 26 μm or less, 25 μm or less, 24 μm or less, 23 μm or less, 22 μm or less, 21 μm or less, 20 μm or less, 19 μm or less, or 18 μm or less.

The hologram recording medium of another embodiment is not limited thereto, but may be a medium on which a reflective hologram or a transmissive hologram is recorded.

The hologram recording medium may have a notch filter structure in relation to the diffraction grating structure. The hologram recording medium of another embodiment having a notch filter structure may mean that the diffraction grating is non-slanted (substantially 0°) with respect to the substrate surface, for example, as if the diffraction grating is parallel to the substrate surface. Such a hologram recording medium may have a structure in which two layers having different refractive indexes (e.g., a high refractive index layer and a low refractive index layer) are alternately repeated. Further, the two repeated layers may respectively have a predetermined thickness that is the same or different from each other. Such a non-slanted diffraction grating record can be prepared in such a way that the incident angles of the incident object light and reference light are made equal based on the normal line. In the non-slanted structure, the degree of deformation (e.g., shrinkage or expansion) under high temperature and high humidity conditions is further clearly confirmed compared to the slanted structure, and it is less affected by the shrinkage and expansion of the substrate.

The hologram recording medium of another embodiment can have high diffraction efficiency. In one example, the hologram recording medium may have a diffraction efficiency of 70% or more upon recording a notch filter hologram. Wherein, the thickness of the photopolymer layer may be, for example, 5 to 30 μm. Specifically, when recording the notch filter hologram, the diffraction efficiency may be 71% or more, 72% or more, 73% or more, 74% or more, 75% or more, 80% or more, 81% or more, 82% or more, 83% or more, 84% or more, 85% or more, 86% or more, or 87% or more. In this manner, the hologram recording medium of another embodiment can realize excellent diffraction efficiency even if it includes a photopolymer layer of thin thickness. The diffraction efficiency may be measured by the method described in the Test Example 2 described below.

The hologram recording medium of another embodiment can realize a refractive index modulation value (Δn) of 0.020 or more, 0.025 or more, 0.026 or more, 0.027 or more, 0.028 or more, 0.029 or more, 0.030 or more, 0.031 or more, 0.032 or more, 0.033 or more, 0.034 or more, or 0.035 or more even if the thickness of the photopolymer layer is as thin as 5 to 30 μm. The upper limit of the refractive index modulation value is not particularly limited, but may be, for example, 0.060 or less. The refractive index modulation value may be measured by the method described in the Test Example 2 described below.

The hologram recording medium of another embodiment is expected to provide various optical elements that can

be used in high temperatures, not only exhibiting excellent optical recording characteristics and durability under high temperatures but also high-transparency optical properties.

The use of the hologram recording medium of another embodiment is not particularly limited. By way of non-limiting example, the hologram recording medium may be used in applications likely to be exposed to high temperature environments, specifically, smart devices such as mobile devices, parts of wearable displays, vehicle articles (e.g., head up display) and the like. The hologram recording medium of another embodiment exhibits excellent reliability under high temperatures, enabling it to display the intended optical recording characteristics even under high temperatures.

On the other hand, according to yet another embodiment of the disclosure, there is provided a method for preparing a hologram recording medium, comprising the step of applying a photopolymer composition to form a photopolymer layer.

The photopolymer composition may be the photopolymer composition of one embodiment. Since its components have been described in detail previously, a detailed description will be omitted here.

In the step of forming the photopolymer layer, a photopolymer composition containing the above-mentioned configuration may first be prepared. When preparing the photopolymer composition, for mixing each component, a commonly known blender, stirrer, mixer or the like may be used without particular restriction. Further, such a mixing process may be performed at a temperature ranging from 0°C to 100°C, a temperature ranging from 10°C to 80°C, or a temperature ranging from 20°C to 60°C.

In the step of forming the photopolymer layer, the prepared photopolymer composition may be applied to form a coating layer formed from the photopolymer composition. The coating layer may be dried naturally at room temperature or dried at a temperature of 30°C to 80°C. Through this process, a hydrosilylation reaction between the hydroxyl group of the acrylic-based polyol remaining unreacted and the silane functional group of the siloxane-based polymer may be induced.

In the photopolymer layer prepared through the step of forming the photopolymer layer, a fluorinated compound, a photoreactive monomer, a photoinitiator system, and additives added as necessary may be uniformly dispersed within the crosslinked polymer matrix.

The method for preparing the hologram recording medium according to yet another embodiment may further include a step of recording optical information by irradiating a coherent laser onto a predetermined region of the photopolymer layer and selectively polymerizing the photoreactive monomer contained in the photopolymer layer after the step of forming the photopolymer layer.

In the step of recording optical information, if a coherent laser is irradiated onto the photopolymer layer, polymerization of photoreactive monomers occurs to form a photopolymer in the constructive interference region, and polymerization of photoreactive monomer does not occur or is suppressed in the destructive interference region, so that the photoreactive monomer are present. Further, while the unreacted photoreactive monomer causes refractive index modulation while diffusion occurs toward the photopolymer side where the concentration of photoreactive monomers is lower, and a diffraction grating is produced by the refractive index modulation. Thereby, holograms, i.e. optical information, are recorded on the photopolymer layer having the diffraction grating.

The method for preparing the hologram recording medium according to yet another embodiment may further include a step of photobleaching by irradiating light onto the entire photopolymer layer on which the optical information is recorded after the step of recording the optical information.

In the photobleaching step, ultraviolet rays are irradiated onto the photopolymer layer on which optical information is recorded to terminate the reaction of the photoreactive monomer remaining in the photopolymer layer and remove the color of the photosensitizing dye. In one example, in the photobleaching step, ultraviolet rays (UVA) in the range of 320 to 400 nm are irradiated to terminate the reaction of the photoreactive monomer and remove the color of the photosensitizing dye.

On the other hand, according to a further embodiment of the disclosure, there is provided an optical element comprising the hologram recording medium.

Specific examples of the optical elements may include smart devices such as mobile devices, parts of wearable displays, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

An example of an optical element including the hologram recoding medium may include a hologram display device. The hologram display device includes a light source unit, an input unit, an optical system, and a display unit.

Specifically, the light source unit is a portion that irradiates a laser beam used for providing, recording, and reproducing three-dimensional image information of an object in the input unit and the display unit.

The input unit is a portion that previously inputs three-dimensional image information of an object to be recorded on the display unit, specifically, a portion in which three-dimensional information of an object such as the intensity and phase of light for each space may be inputted into an electrically addressed liquid crystal SLM, wherein an input beam may be used.

The optical system may include a mirror, a polarizer, a beam splitter, a beam shutter, a lens, and the like. The optical system may be distributed into an input beam for sending a laser beam emitted from the light source unit to the input unit, a recording beam for sending the laser beam to the display unit, a reference beam, an erasing beam, a reading beam, and the like.

The display unit may receive three-dimensional image information of an object from an input unit, record it on a hologram plate comprising an optically addressed SLM, and reproduce the three-dimensional image of the object. At this time, the three-dimensional image information of the object may be recorded via interference of the input beam and the reference beam. The three-dimensional image information of the object recorded on the hologram plate may be reproduced into a three-dimensional image by the diffraction pattern generated by the reading beam. The erasing beam may be used to quickly remove the formed diffraction pattern. On the other hand, the hologram plate may be moved between a position at which a three-dimensional image is inputted and a position at which a three-dimensional image is reproduced.

## [ADVANTAGEOUS EFFECTS]

According to one embodiment of the disclosure, the photopolymer composition is able to provide a hologram recording medium and an optical element comprising the same, which exhibit not only excellent optical recording characteristics but also outstanding reliability and transparency even under high temperatures.

## [BRIEF DESCRIPTION OF THE DRAWINGS]

FIG. 1 schematically shows the recording equipment setup for hologram recording. Specifically, FIG. 1 schematically shows the process in which a laser of a predetermined wavelength is radiated from the light source 10, and irradiated onto the PP (hologram recording medium) 80 located on one surface of a mirror 70 via mirrors 20 and 20', an iris 30, a spatial filter 40, an iris 30', a collimation lens 50, and PBS (Polarized Beam Splitter) 60.

## [DETAILED DESCRIPTION OF THE EMBODIMENTS]

Hereinafter, the action and effect of the invention will be described in more detail with reference to specific examples of the invention. However, these examples are presented for illustrative purposes only, and the scope of the invention is not limited thereby in any way.

In the following Preparation Examples, Examples, Comparative Examples, and the like, the content of raw materials, and the like means the content based on solid content, unless otherwise specified.

### Preparation Example 1: Preparation of acrylic-based polyol

132 g of butyl acrylate, 420 g of ethyl acrylate, and 48 g of hydroxybutyl acrylate were added to a 2 L jacketed reactor, and diluted with 1200 g of ethyl acetate. The reaction temperature was set to 60~70°C, and the mixture was stirred for about 30 minutes to 1 hour. 0.42 g of n-dodecyl mercaptan (n-DDM) was further added, and stirring was further performed for about 30 minutes. Then, 0.24 g of AIBN as a polymerization initiator was added, polymerization was performed at the reaction temperature for 4 hours or more, and kept until the residual acrylate content became less than 1%. Thereby, an acrylate-based copolymer (weight average molecular weight of about 300,000, OH equivalent of about 1802 g/equivalent) in which the hydroxy group was located in the branched chain was prepared.

### Example 1: Preparation of photopolymer composition and hologram recording medium

(1) Preparation of photopolymer composition

First, 0.57 g of poly(methylhydrosiloxane) (Sigma-Aldrich, number average molecular weight: about 590, Si-H equivalent: about 103 g/equivalent) as a siloxane-based polymer and 33.4 g of the acrylic-based polyol (solid content: 10.02 g) prepared in Preparation Example 1 (solid content: 30 wt%) were mixed (SiH/OH molar ratio = 1.0).

Then, 11.5 g of HR 6042 (Miwon Specialty Chemical, refractive index of 1.60) as a photoreactive monomer, 0.08 g of photosensitizing dye H-Nu 640 (Spectra Group), 0.3 g of borate V as a co-initiator, 11.5 g of the fluorinated compound represented by the following Chemical Formula a as a plasticizer and 26 g of methyl isobutyl ketone (MIBK) as a solvent were added, and the mixture was stirred with a paste mixer for about 30 minutes while blocking light. After that, a photopolymer composition was prepared by adding Karstedt (Pt-based) catalyst for matrix crosslinking.

[Chemical Formula a]

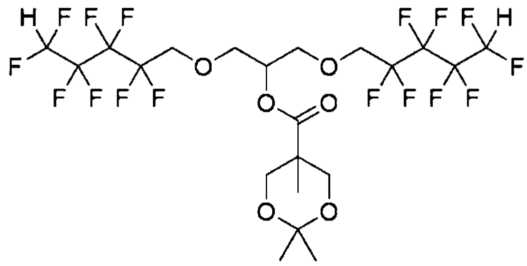

(2) Preparation of hologram recording medium

The photopolymer composition was coated to a predetermined thickness on a 60 μm thick TAC substrate using a Mayer bar, and dried at 80°C for 10 minutes. The thickness of the photopolymer layer after drying was about 10 μm.

**<u>Examples 2, 3 and Comparative Examples 1 and 2: Preparation of photopolymer composition and hologram recording medium</u>**

A photopolymer composition and a hologram recording medium were prepared in the same manner as in Example 1, except that the plasticizer was changed as shown in Table 1 below.

**[Table 1]**

| | Plasticizer |
|---|---|
| Example 1 | [Chemical Formula a] |
| | 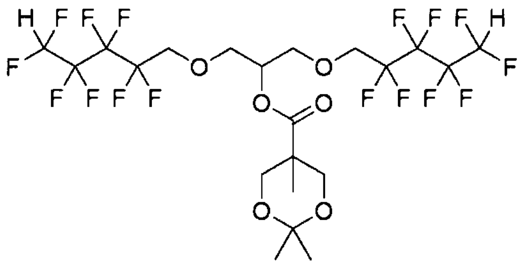 |
| Example 2 | [Chemical Formula b] 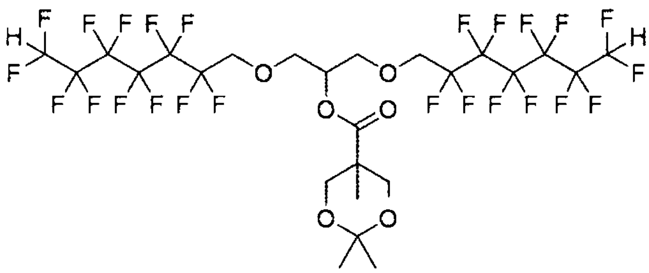 |
| Example 3 | [Chemical Formula c] 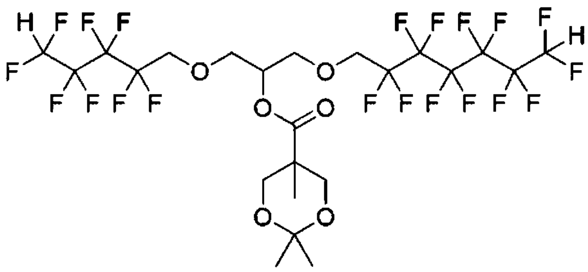 |

(continued)

| | Plasticizer |
|---|---|
| Comparative Example 1 | [Chemical Formula d] 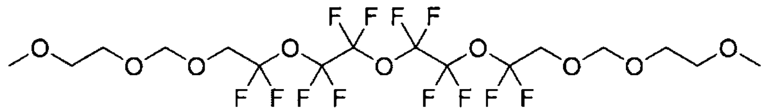 |
| Comparative Example 2 | [Chemical Formula e] 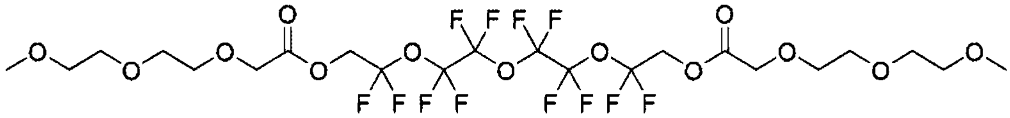 |

Test Example 1: Evaluation of the migration degree of hologram recording medium

The migration degree of the hologram recording medium before recording was evaluated at various temperatures. Specifically, to evaluate the migration degree of the photopolymer layer at various temperatures, the refractive index from the surface to the center of the photopolymer layer was measured at various temperatures using spectroscopic ellipsometry (Ellipso Technology) at an incident angle of 70° and in the wavelength range of 320 to 1680 nm.

The thickness (A1) of the different refractive layer exhibiting a refractive index difference of at least 0.0010% from the central refractive index of the photopolymer layer and the thickness (A2) of the remaining portion of the photopolymer layer were measured at various temperatures, and the values are shown in Table 2 below.

Furthermore, the percentage (Pn) of the thickness (A1) of the different refractive layer relative to the total thickness (A1+A2) of the photopolymer layer at various temperatures was calculated according to the following Equation 1, and is shown in Table 2 below.

[Equation 1]

$$Pn\ (\%) = \{A1 / (A1 + A2)\} \times 100$$

In Equation 1, Pn is the thickness ratio of the different refractive layer formed at n °C,

A1 is the thickness of the different refractive layer formed at n °C, where the different refractive layer refers to the portion at the surface of the photopolymer layer exhibiting a refractive index difference of at least 0.0010% from the central refractive index measured at an incident angle of 70° and in the wavelength range of 320 to 1680 nm, and

A2 is the thickness of the remainder of the photopolymer layer excluding the different refractive layer.

**[Table 2]**

| | | Example 1 | Comparative Example 1 |
|---|---|---|---|
| 23 °C | A1 | 0.0076 | 0.0094 |
| | A2 | 15.6567 | 16.3077 |
| | P23 | 0.05 % | 0.06 % |
| 40 °C | A1 | 0.0127 | 0.0303 |
| | A2 | 15.7850 | 16.3352 |
| | P40 | 0.08 % | 0.19 % |
| 60 °C | A1 | 0.0110 | 0.0404 |
| | A2 | 15.9307 | 16.5539 |
| | P60 | 0.07 % | 0.24 % |

(continued)

| | | Example 1 | Comparative Example 1 |
|---|---|---|---|
| 80 °C | A1 | 0.0085 | 0.0740 |
| | A2 | 16.0477 | 16.7313 |
| | P80 | 0.05 % | 0.44 % |

Meanwhile, the migration degree of the hologram recording medium before recording was evaluated at various temperatures by measuring the refractive indices at the center and at the surface of the photopolymer layer at various temperatures and wavelengths, and are shown in Table 3 below. The refractive index was measured using the same equipment described above.

**[Table 3]**

| | | Example 1 | | Comparative Example 1 | |
|---|---|---|---|---|---|
| Temperature | Wavelength | Refractive index at the center | Refractive index at the surface within 0.05 % of thickness | Refractive index at the center | Refractive index at the surface within 0.05 % of thickness |
| 23 °C | 530 nm | 1.5089 | 1.5093 | 1.5207 | 1.5396 |
| | 580 nm | 1.5032 | 1.5022 | 1.5184 | 1.5339 |
| | 650 nm | 1.4988 | 1.4950 | 1.5161 | 1.5254 |
| | 850 nm | 1.4926 | 1.4837 | 1.5132 | 1.5162 |
| 40 °C | 530 nm | 1.5050 | 1.5086 | 1.5196 | 1.4527 |
| | 580 nm | 1.5009 | 1.5006 | 1.5174 | 1.4486 |
| | 650 nm | 1.4975 | 1.4932 | 1.5143 | 1.4429 |
| | 850 nm | 1.4884 | 1.4822 | 1.5102 | 1.4371 |
| 60 °C | 530 nm | 1.4971 | 1.5182 | 1.5137 | 1.4072 |
| | 580 nm | 1.4937 | 1.5107 | 1.5121 | 1.4046 |
| | 650 nm | 1.4920 | 1.5077 | 1.4988 | 1.4019 |
| | 850 nm | 1.4809 | 1.4941 | 1.4911 | 1.3955 |
| 80 °C | 530 nm | 1.4926 | 1.5178 | 1.5133 | 1.4170 |
| | 580 nm | 1.4890 | 1.5096 | 1.5112 | 1.4115 |
| | 650 nm | 1.4854 | 1.5060 | 1.4972 | 1.4029 |
| | 850 nm | 1.4788 | 1.4922 | 1.4877 | 1.3983 |

Referring to Tables 2 and 3, it was confirmed that a very thin different refractive layer was formed in the photopolymer layer of Example 1 with a negligible thickness that did not affect the function of the hologram recording medium, and the absolute difference in refractive index between the center and the surface was also very small.

In contrast, it was confirmed that a different refractive layer was formed in the photopolymer layer of Comparative Example 1 with a significantly thicker thickness that would detrimentally affect the function of the hologram recording medium, and the absolute difference in refractive index between the center and the surface was also very large.

Test Example 2: Performance evaluation of hologram recording medium

(1) P80 (the thickness ratio of the different refractive layer formed at 80 °C, %)

The migration degree of the hologram recording medium before recording was evaluated at high temperatures. Specifically, to evaluate the migration degree of the photopolymer layer at 80 °C, the refractive index from the surface to the center of the photopolymer layer was measured at 80 °C using spectroscopic ellipsometry (Ellipso Technology) at an incident angle of 70° and in the wavelength range of 320 to 1680 nm.

Then, P80 (the thickness ratio of the different refractive layer formed at 80 °C) was calculated according to the following Equation 1, and is shown in Table 4 below.

[Equation 1]

$$Pn\ (\%) = \{A1 / (A1 + A2)\} \times 100$$

In Equation 1, Pn is the thickness ratio of the different refractive layer formed at n °C,

A1 is the thickness of the different refractive layer formed at n °C, where the different refractive layer refers to the portion at the surface of the photopolymer layer exhibiting a refractive index difference of at least 0.0010% from the central refractive index measured at an incident angle of 70° and in the wavelength range of 320 to 1680 nm, and A2 is the thickness of the remainder of the photopolymer layer excluding the different refractive layer.

(2) △H80 (the haze increase at 80 °C, %p)

A diffraction grating was recorded using the same setup as shown in FIG. 1. Specifically, when the prepared photopolymer layer was laminated on a mirror and then irradiated with a laser, a notch filter hologram with periodic refractive index modulation in the thickness direction could be recorded through interference between incident light (L) and light reflected from the mirror (L'). In this example, a notch filter hologram was recorded with an incident angle of 0° (degree). Notch filter and Bragg reflector are optical devices that reflect only light of a specific wavelength, and have a structure in which two layers with different refractive indices are stacked periodically and repeatedly at a constant thickness.

The haze difference before and after high-temperature exposure of the hologram recording medium with the recorded diffraction grating was evaluated. Haze was measured using a HAZE METER (HM-150) by Murakami Color Research Laboratory in accordance with JIS K 7136. The measurement light was incident on the substrate side surface of the hologram recording medium.

Specifically, the hologram recording medium was stored at 80 °C for 100 hours, and the haze difference before and after being stored was calculated according to the following Equation 2 and the haze increase (△H80) at 80 °C is shown in Table 4 below.

[Equation 2]

$$\triangle Hn\ (\%p) = B2 - B1$$

In Equation 2, △Hn is the haze increase of the hologram recording medium at n °C,

B1 is the initial haze of the hologram recording medium before being stored at n °C, and
B2 is the haze after the hologram recording medium is stored at n °C for 100 hours.

(3) Diffraction efficiency

Diffraction efficiency (η) was determined through the following Equation 3 for the hologram recording medium with the recorded diffraction grating.

[Equation 3]

$$\eta\ (\%) = \{P_D / (P_D + P_T)\}\ X\ 100$$

in Equation 3, η is the diffraction efficiency, $P_D$ is the output amount (mW/ $cm^2$) of the diffracted beam of the sample after recording, and $P_T$ is the output amount (mW/$cm^2$) of the transmitted beam of the sample after recording.

(4) Refractive index modulation value (△n)

The refractive index modulation value (△n) was determined through the following Equation 4 and Bragg's equation for the hologram recording medium with the recorded diffraction grating.

[Equation 4]

$$\eta = tanh^2 \left| \frac{\pi \Delta n d}{\lambda (cos^2\theta - \frac{\lambda}{n\Lambda} cos\phi)^{1/2}} \right|$$

[Bragg's Equation]

$$\cos(\theta - \phi) = \frac{\lambda}{2n\Lambda}$$

wherein, in Equations, η is the reflectance diffraction efficiency (DE), d is the thickness of the photopolymer layer, λ is the wavelength of incident light for recording (660 nm or 532 nm), θ is the angle of incidence of the incident light for recording, ϕ is the slant angle of the grating, △n is the refractive index modulation value, n is the refractive index of the photopolymer, and Λ means the diffraction grating period. In the above Examples and Comparative Examples, since holograms were recorded using the notch filter method, both θ (incident angle) and ϕ (slant angle of the grating) were 0°.

**[Table 4]**

| | Diffraction efficiency (%) | Refractive index modulation value (△n) | P80 (%) | △H80 (%p) |
|---|---|---|---|---|
| Example 1 | 87 | 0.037 | 0.05 | 1.0 |
| Example 2 | 85 | 0.035 | 0.07 | 0.7 |
| Example 3 | 87 | 0.037 | 0.04 | 0.9 |
| Comparative Example 1 | 52 | 0.022 | 0.44 | 15.2 |
| Comparative Example 2 | 47 | 0.019 | 0.40 | 14.8 |

Referring to Table 4, it was confirmed that the hologram recording media manufactured in Examples 1 to 3 exhibited high diffraction efficiencies and refractive index modulation values, and had excellent high-temperature stability, so that the degree of formation of the different refractive layer was minimal, and the increase in haze was also very small. In contrast, it was confirmed that the hologram recording media manufactured in Comparative Examples 1 and 2 had poor optical recording characteristics, and in particular, the different refractive layer was formed thickly at high temperatures, and the haze increased significantly.

Hence, it was confirmed that the photopolymer composition according to one embodiment of the disclosure, by including a fluorinated compound having a specific structure, can provide a hologram recording medium exhibiting outstanding optical recording characteristics, high-temperature stability, and high transparency.

## Claims

**1.** A photopolymer composition comprising:

a polymer matrix formed by crosslinking a siloxane-based polymer containing a silane functional group and an acrylic-based polyol, or a precursor thereof;
a fluorinated compound represented by the following Chemical Formula 1;
a photoreactive monomer; and a photoinitiator system:

[Chemical Formula 1]

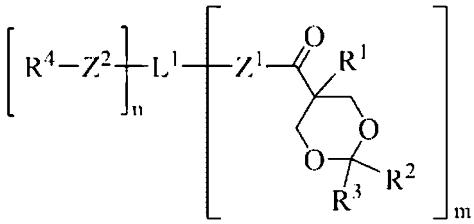

In Chemical Formula 1,

$Z^1$ is -O- or -NH-,
$Z^2$ is a single bond, -O-, or -NH-,
$L^1$ is a single bond or a divalent to hexavalent organic group in which hydroxy groups have been removed from a polyol having 2 to 6 hydroxyl groups,
n and m are each independently an integer of 1 to 5, wherein the sum of n and m is 2 to 6,
$R^1$, $R^2$, and $R^3$ are each independently methyl or ethyl,
$R^4$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines.

2. The photopolymer composition according to claim 1, wherein the siloxane-based polymer comprises a repeating unit represented by the following Chemical Formula 2 and a terminal end group represented by the following Chemical Formula 3:

[Chemical Formula 2]

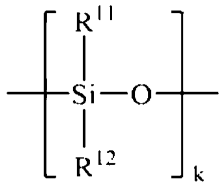

in Chemical Formula 2,

a plurality of $R^{11}$ and $R^{12}$ are the same or different from each other, and are each independently hydrogen, halogen, or an alkyl group having 1 to 10 carbon atoms, and
k is an integer of 1 to 10,000,

[Chemical Formula 3]

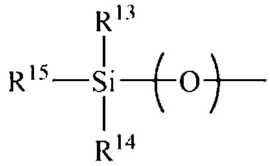

in Chemical Formula 3,
a plurality of $R^{13}$ to $R^{15}$ are the same or different from each other, and are each independently hydrogen, halogen, or an alkyl group having 1 to 10 carbon atoms, and
at least one of $R^{11}$ to $R^{15}$ of at least one repeating unit selected among the repeating units represented by Chemical Formula 2 and any one terminal end group selected among the terminal end groups represented by Chemical Formula 3 is hydrogen.

3. The photopolymer composition according to claim 1, wherein the acrylic-based polyol is a polymer in which a hydroxy group is bonded to the main chain or side chain of an acrylate-based polymer.

4. The photopolymer composition according to claim 1, wherein the photoreactive monomer comprises at least one monofunctional monomer selected from the group consisting of benzyl (meth)acrylate, benzyl 2-phenylacrylate, phenoxybenzyl (meth)acrylate, phenol (ethylene oxide) (meth)acrylate, phenol (ethylene oxide)$_2$ (meth)acrylate, O-phenylphenol (ethylene oxide) (meth)acrylate, phenylthioethyl (meth)acrylate and biphenylmethyl (meth)acrylate; at least one polyfunctional monomer selected from the group consisting of bisphenol A (ethylene oxide)$_{2-10}$ di(meth) acrylate, bisphenol A epoxy di(meth)acrylate, bisfluorene di(meth)acrylate, modified bisphenol fluorene di(meth) acrylate, tris(2-hydroxyethyl)isocyanurate tri(meth)acrylate, phenol novolac epoxy (meth)acrylate and cresol novolac epoxy (meth)acrylate; or a mixture of two or more thereof.

5. The photopolymer composition according to claim 1, wherein the photoreactive monomer is contained in an amount of 50 to 300 parts by weight based on 100 parts by weight of the polymer matrix.

6. The photopolymer composition according to claim 1, wherein the photoinitiator system comprises a photosensitizing dye and a co-initiator.

7. The photopolymer composition according to claim 6, wherein the co-initiator comprises a borate anion represented by the following Chemical Formula 4:

[Chemical Formula 4] $BX^1X^2X^3X^4$

in Chemical Formula 4, $X^1$ to $X^4$ are each independently an alkyl group having 1 to 20 carbon atoms, an alkenyl group having 2 to 20 carbon atoms, an aryl group having 6 to 30 carbon atoms, an arylalkyl group having 7 to 30 carbon atoms, an alkylaryl group having 7 to 30 carbon atoms, or an allyl group, each of which is substituted or unsubstituted, with the proviso that at least one of $X^1$ to $X^4$ is not an aryl group.

8. The photopolymer composition according to claim 1, wherein $L^1$ in Chemical Formula 1 is a single bond; or a trivalent organic group in which hydroxy groups have been removed from glycerol which is a triol.

9. The photopolymer composition according to claim 1, wherein the fluorine-containing substituent is a straight chain alkyl group having 1 to 20 carbon atoms substituted with 2 or more fluorines.

10. The photopolymer composition according to claim 1, wherein the fluorine-containing substituent is $-(CH_2)_a(CF_2)_bCHF_2$ or $-(CH_2)_a(CF_2)_bCF_3$, where a is an integer of 0 to 3, and b is an integer of 0 to 19.

11. The photopolymer composition according to claim 1, wherein the fluorinated compound represented by Chemical Formula 1 comprises at least one fluorinated compound selected from the group consisting of fluorinated compounds represented by the following Chemical Formula 1-1 and the following Chemical Formula 1-2:

[Chemical Formula 1-1]

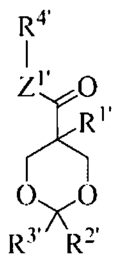

in Chemical Formula 1-1,

$Z^{1'}$, $R^{1'}$, $R^{2'}$, $R^{3'}$ and $R^{4'}$ are the same as $Z^1$, $R^1$, $R^2$, $R^3$ and $R^4$ in Chemical Formula 1, respectively,

[Chemical Formula 1-2]

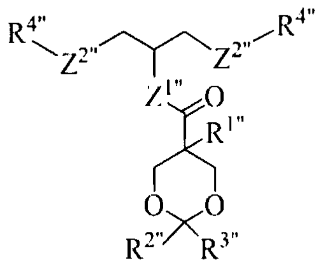

in Chemical Formula 1-2,
$Z^{1"}$, $Z^{2"}$, $R^{1"}$, $R^{2"}$, $R^{3"}$ and $R^{4"}$ are the same as $Z^1$, $Z^2$, $R^1$, $R^2$, $R^3$ and $R^4$ of Chemical Formula 1, respectively.

**12.** The photopolymer composition according to claim 1, wherein the fluorinated compound represented by Chemical Formula 1 is contained in an amount of 20 to 200 parts by weight based on 100 parts by weight of the polymer matrix.

**13.** A hologram recording medium comprising a photopolymer layer formed from the photopolymer composition according to claim 1.

**14.** A method for preparing a hologram recording medium, comprising a step of applying the photopolymer composition according to claim 1 to form a photopolymer layer.

**15.** The method according to claim 14, further comprising a step of recording optical information by irradiating a coherent laser onto a predetermined region of the photopolymer layer and selectively polymerizing the photoreactive monomer contained in the photopolymer layer.

**16.** An optical element comprising the hologram recording medium according to claim 13.

【FIG. 1】

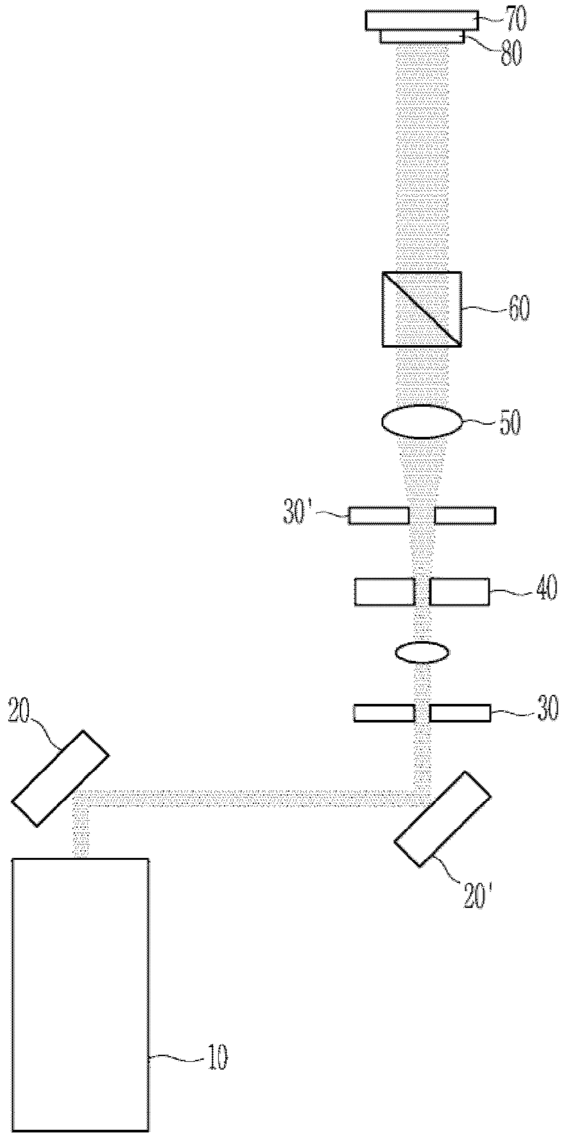

## INTERNATIONAL SEARCH REPORT

International application No.
**PCT/KR2025/002192**

**A. CLASSIFICATION OF SUBJECT MATTER**

**G03F 7/075**(2006.01)i; **C08F 287/00**(2006.01)i; **C08F 2/44**(2006.01)i; **C08F 2/50**(2006.01)i; **C08G 77/42**(2006.01)i; **C08G 77/38**(2006.01)i; **C08G 77/12**(2006.01)i; **C08K 5/101**(2006.01)i; **G03F 7/004**(2006.01)i; **G03F 7/027**(2006.01)i

According to International Patent Classification (IPC) or to both national classification and IPC

**B. FIELDS SEARCHED**

Minimum documentation searched (classification system followed by classification symbols)

G03F 7/075(2006.01); C07C 321/04(2006.01); C08F 2/44(2006.01); C08F 275/00(2006.01); C08F 283/12(2006.01); C08G 65/16(2006.01); C08L 33/10(2006.01); C09D 4/00(2006.01); C09K 19/56(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus) & keywords: 포토폴리머(photopolymer), 실록산계 고분자(siloxane-based polymer), 아크릴계 폴리올(acrylic polyol), 고분자 매트릭스(polymer matrix), 불소계 화합물(fluorine-based compound), 광반응성 단량체(photoreactive monomer), 광개시제(photoinitiator)

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0003510 A (LG CHEM, LTD.) 12 January 2021 (2021-01-12)<br>See claims 1, 10 and 14-16; and paragraphs [0076]-[0080]. | 1-16 |
| A | JP 2009-079089 A (FUJIFILM CORP.) 16 April 2009 (2009-04-16)<br>See claims 1, 6 and 9; and paragraphs [0011]-[0022], [0030], [0043], [0067] and [0069]. | 1-16 |
| A | KR 10-2023-0083786 A (LG CHEM, LTD.) 12 June 2023 (2023-06-12)<br>See claims 1, 3-5, 11, 14, 19, 20, 22 and 23; and paragraphs [0065]-[0068] and [0157]. | 1-16 |
| A | KR 10-2022-0112996 A (LG CHEM, LTD.) 12 August 2022 (2022-08-12)<br>See claims 1, 2, 11, 14 and 15; and paragraphs [0136]-[0140]. | 1-16 |
| A | US 2010-0266821 A1 (BURY, I. et al.) 21 October 2010 (2010-10-21)<br>See claims 1 and 3-5; paragraphs [0218] and [0219]; and table C. | 1-16 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 May 2025** | **13 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2025/002192**

| Patent document cited in search report | Publication date (day/month/year) | Patent family member(s) | Publication date (day/month/year) |
|---|---|---|---|
| KR 10-2021-0003510 A | 12 January 2021 | CN 112639617 A | 09 April 2021 |
| | | CN 112639617 B | 23 August 2024 |
| | | EP 3838937 A1 | 23 June 2021 |
| | | EP 3838937 B1 | 14 September 2022 |
| | | JP 2021-536039 A | 23 December 2021 |
| | | JP 7130306 B2 | 05 September 2022 |
| | | KR 10-2384288 B1 | 06 April 2022 |
| | | US 11851515 B2 | 26 December 2023 |
| | | US 2021-0340302 A1 | 04 November 2021 |
| | | WO 2021-002648 A1 | 07 January 2021 |
| JP 2009-079089 A | 16 April 2009 | None | |
| KR 10-2023-0083786 A | 12 June 2023 | None | |
| KR 10-2022-0112996 A | 12 August 2022 | EP 4120018 A1 | 18 January 2023 |
| | | US 2023-0142827 A1 | 11 May 2023 |
| | | WO 2022-169307 A1 | 11 August 2022 |
| US 2010-0266821 A1 | 21 October 2010 | EP 2222740 A1 | 01 September 2010 |
| | | EP 2222740 B1 | 11 October 2017 |
| | | TW 200930794 A | 16 July 2009 |
| | | TW I418612 B | 11 December 2013 |
| | | US 9499649 B2 | 22 November 2016 |
| | | WO 2009-080147 A1 | 02 July 2009 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020240022505